Europäisches Patentamt

European Patent Office

Office européen des brevets

(19)

(11) Veröffentlichungsnummer: **0 157 288 B1**

(12) **EUROPÄISCHE PATENTSCHRIFT**

(45) Veröffentlichungstag der Patentschrift: **14.08.91**

(51) Int. Cl.⁵: **H05K 13/04**, H05K 13/08

(21) Anmeldenummer: **85103205.2**

(22) Anmeldetag: **19.03.85**

(54) Einrichtung für die Handbestückung von Leiterplatten.

(30) Priorität: **22.03.84 DE 3410574**

(43) Veröffentlichungstag der Anmeldung:
**09.10.85 Patentblatt 85/41**

(45) Bekanntmachung des Hinweises auf die
Patenterteilung:
**14.08.91 Patentblatt 91/33**

(84) Benannte Vertragsstaaten:
**AT BE CH DE FR GB IT LI LU NL SE**

(56) Entgegenhaltungen:
**EP-A- 0 027 054**
**FR-A- 2 517 166**
**US-A- 3 859 707**

(73) Patentinhaber: **Siemens Aktiengesellschaft**
**Wittelsbacherplatz 2**
**W-8000 München 2(DE)**

(72) Erfinder: **Klink, Gerhard**
**Freimannerweg 14**
**W-8046 Garching(DE)**
Erfinder: **Kraske, Dietmar**
**Schuckertstrasse 5**
**W-8000 München 70(DE)**
Erfinder: **Edinger, Egon**
**Buchenstrasse 3**
**W-8033 Krailling(DE)**
Erfinder: **Kötter, Joachim, Dipl.-Ing.**
**Auenstrasse 70**
**W-8000 München 55(DE)**
Erfinder: **Krumrey, Klaus**
**Pulvermühlweg 396**
**W-6720 Speyer(DE)**
Erfinder: **Mayser, Jörg, Dipl.-Ing.**
**Dittmanns-Wiesen 4a**
**W-7520 Bruchsal(DE)**
Erfinder: **Michael, Ulrich, Dipl.-Ing.**
**Bergstrasse 90**
**W-8035 Stockdorf(DE)**

## Beschreibung

Die Erfindung betrifft eine Einrichtung für die Handbestückung von Leiterplatten mit elektrischen und/oder elektronischen Bauelementen, mit

- einer Aufnahme für die unverwechselbare Positionierung der zu bestückenden Leiterplatten,
- einer Anzeigeeinrichtung zur optischen Kennzeichnung der jeweiligen Bestückpositionen der Bauelemente auf der in der Aufnahme positionierten Leiterplatte,
- mindestens einem Magazin zur Bereitstellung der für die Bestückung benötigten Bauelemente und mit
- einer Recheneinrichtung, welche die Anzeigeeinrichtung und die Entnahmepositionen der Bauelemente im Magazin entsprechend einem vorgebbaren Bestückprogramn steuert.

Eine derartige Einrichtung für die Handbestückung von Leiterplatten, die in der Praxis auch kurz als Handbestückplatz bezeichnet wird, ist beispielsweise aus der Firmendruckschrift "IDAS 402", 9/83 der Firma G.E. Schlup & Co. P.O.B. 26 CH-2543 Lengnau bekannt. Bei diesem bekannten Handbestückplatz werden die zu bestückenden Leiterplatten in einer Aufnahme positioniert, die in einer pultförmig schräg gestellten Fläche eines Arbeitstisches angeordnet ist. Auf dem Arbeitstisch stehen ferner zwei turmförmige Hub- und Drehmagazine mit in mehreren Ebenen sektorförmig angeordneten Fächern, in welchen die für die Bestückung benötigten Bauelemente bereitgestellt werden. Eine Anzeigeeinrichtung dient zur optischen Kennzeichnung der jeweiligen Bestückpositionen der Bauelemente auf der in der Aufnahme positionierten Leiterplatte, wobei die optische Anzeige bzw. Kennzeichnung direkt in die Bohrungen der Leiterplatte gerichtet ist. Auf einem separaten Gestell neben dem Arbeitstisch ist eine Recheneinrichtung mit Bildschirm und einem Programmtastenfeld angeordnet. Sollen nun zu einem Los zusammengefaßte Leiterplatten bestückt werden, so wird zunächst eine auf die Losgröße abgestellte Menge der für die Bestückung benötigten Bauelemente für die Bestückung vorbereitet und in die einzelnen Fächer der beiden Hub- und Drehmagazine einsortiert. Danach wird über das Programmiertastenfeld ein den zu bestückenden Leiterplatten zugeordnetes Bestückprogramm in die Recheneinrichtung eingegeben, wobei der Bildschirm eine fortlaufende Kontrolle der eingegebenen Daten ermöglicht. Die auf diese Weise eingegebenen Daten definieren dabei insbesondere die Lichtpunkte der jeweiligen Bestückpositionen und die Reihenfolge der Fächer der beiden Hub- und Drehmagazine entsprechend dem Bestückungsablauf. Beim nachfolgenden Bestücken steuert dann die Recheneinrichtung die Anzeigeeinrichtung und die Hub- und Drehmagazine derart, daß die jeweiligen Bestückpositionen auf der Leiterplatte gekennzeichnet und die Fächer der Hub- und und Drehmagazine mit den entsprechenden Bauelementen freigegeben werden.

Der bekannte Handbestückplatz ist insbesondere für die Bestückung einer Vielzahl gleicher und zu einem Los zusammengefaßter Leiterplatten geeignet. Bei einem Loswechsel ist eine Umrüstung des Handbestückplatzes mit einem Einsortieren der jetzt benötigten und entsprechend vorbereiteten Bauelemente in die beiden Hub- und Drehmagazine und mit einer Eingabe des neuen Bestückprogramms in die Recheneinrichtung erforderlich.

Aus US-A- 3859707 ist ferner eine Einrichtung für die Handbestückung von Leiterplatten mit elektrischen und/oder elektronischen Bauelementen bekannt, die einen Computer, einen Projektionsapparat, eine Positionierungsgrundplatte und ein mit 60 Behältern für die Bauelemente versehenes Karussell aufweist. Aufgrund der 60 Behälter, deren Ort und Inhalt der Computer kennt, kann die Einrichtung für die meisten Arbeiten ohne Austausch des Karussells oder ohne Neuordnung oder Austausch der Behälter programmiert werden.

Der Erfindung liegt die Aufgabe zugrunde, eine Einrichtung für die Handbestückung von Leiterplatten zu schaffen, bei welcher ohne Umrüstaufwand und ohne Bindung an Losgrößen verschiedene Typen der Leiterplatten unmittelbar nacheinander mit den entsprechenden Bauelementen bestückt werden können.

Diese Aufgabe wird bei einer Einrichtung gemäß dem Anspruch 1 gelöst.

Bei der erfindungsgemäßen Einrichtung werden also sämtliche Bauelemente, die für ein zu fertigendes Flachbaugruppenspektrum benötigt werden, in einem Magazin oder ggf. in zwei oder mehreren Magazinen bereitgestellt. Unter dem Begriff Flachbaugruppenspektrum ist hierbei eine Vielzahl verschiedener Typen von Leiterplatten zu verstehen, die in Abhängigkeit des vorhandenen Variantenreichtums sämtliche zu fertigenden Typen oder die Typen einer Produktfamilie oder die Typen eines Produkts umfassen kann. Ein Umrüstaufwand durch die Eingabe der jeweils erforderlichen Bestückprogramme wird bei der erfindungsgemäßen Einrichtung dadurch vermieden, daß die Recheneinrichtung Zugriff zu sämtlichen Bestückprogrammen des zu fertigenden Flachbaugruppenspektrums hat. Dieser Zugriff wird beispielsweise dadurch ermöglicht, daß in der Recheneinrichtung sämtliche Bestückprogramme gespeichert werden oder daß die Recheneinrichtung die einzelnen Bestückprogramme von einem übergeordneten Rechner ab holt. Die Bestückprogramme können aber auch in Programmkassetten enthalten sein, die durch eine entsprechende Wechseleinrichtung automatisch anwählbar und automatisch in die Recheneinrichtung einsetzbar sind. Einen wesentlichen Bestandteil der erfindungsgemäßen Einrichtung bildet schließlich eine Identifiziereinrichtung, welche die jeweils zu bestückenden Leiterplatten identifiziert und selbsttätig das zugeordnete Bestückprogramm in der Recheneinrichtung aktiviert.

Die mit der Erfindung erzielten Vorteile bestehen insbesondere darin, daß der Aufwand für auftrags- bzw. typbezogenes Rüsten völlig entfällt und die Bauelemente nur noch verbrauchsbezogen in das Magazin oder die Magazine einsortiert werden müssen. Es entsteht ein völlig neues Ablaufkonzept, bei dem keine Zusammenfassung zu Losen erforderlich ist und die Fertigung bei erheblicher Reduzierung des Lageraufwands auf den tatsächlichen Bedarf abgestellt werden kann. So können beispielsweise auch Eilaufträge ohne Sonderbehandlung in die laufende Fertigung einbezogen werden.

Vorteilhafte Ausgestaltungen der Erfindung gehen aus den Unteransprüchen hervor.

Ausführungsbeispiele der Erfindung werden im folgenden anhand der Zeichnung näher erläutert.

Es zeigen:

Figur 1 einen Handbestückplatz für die Bestückung von Leiterplatten mit elektrischen und/oder elektronischen Bauelementen in stark vereinfachter schematischer Darstellung,

Figur 2 und Figur 3 das Funktionsprinzip eines Unterwerkzeugs des in Figur 1 dargestellten Handbestückplatzes,

Figur 4 eine zweite Ausführungsform eines Handbestückplatzes in sehr stark vereinfachter schematischer Darstellung und

die Figuren 5 und 6 das Funktionsprinzip einer Bauelemente-Vorbereitungseinrichtung.

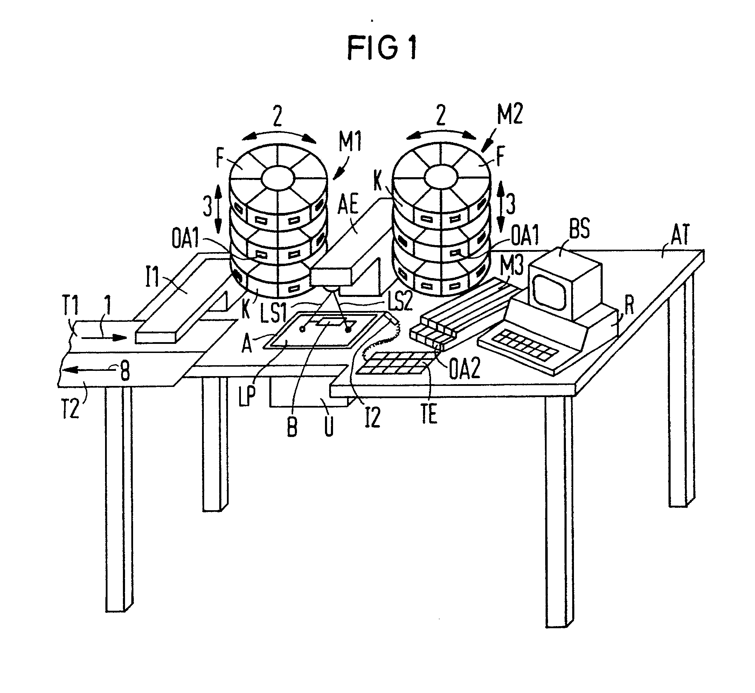

Figur 1 zeigt in perspektivischer Darstellung einen Arbeitstisch AT, auf dessen Arbeitsfläche eine stationäre Identifiziereinrichtung I1, zwei turmförmige Hub- und Drehmagazine M1 und M2 mit in jeweils drei ebenen sektorförmig angeordneten Fächern F, eine Anzeigeeinrichtung AE, eine Aufnahme A für die Positionierung von Leiterplatten LP, eine als Handleseeinrichtung ausgebildete Identifiziereinrichtung 12, eine Tastatureinheit TE, mehrere Stangenmagazine M3 und eine Recheneinrichtung R mit zugehörigem Bildschirm BS angeordnet sind. Auf der linken Seite des Arbeitstisches AT sind eine erste Transporteinrichtung T1 für die Zufuhr der zu bestückenden Leiterplatten LP mit Bauelementen B und eine zweite Transporteinrichtung T2 für den Abtransport der fertig bestückten Leiterplatten LP bzw. Flachbaugruppen zu erkennen. Ferner ist auf der Unterseite der Arbeitsfläche des Arbeitstisches AT ein in der Zeichnung lediglich als Kasten dargestelltes Unterwerkzeug U zu erkennen.

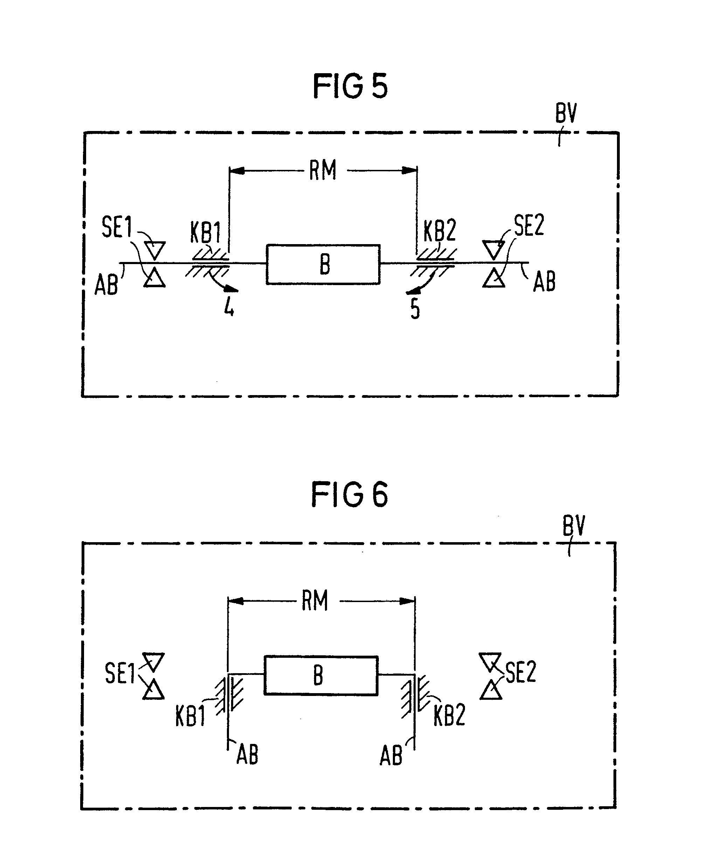

Bei dem in Figur 1 dargestellten Handbestückplatz werden die zu bestückenden Leiterplatten LP über die beispielsweise als Transportband ausgebildete Transporteinrichtung T1 in Richtung des Pfeiles 1 unter der Identifiziereinrichtung I1 hindurch auf die Arbeitsfläche des Arbeitstisches AT transportiert. Die Identifiziereinrichtung I1 tastet mit Hilfe eines Laser-Scanners auf die Leiterplatte LP zur Kennzeichnung der jeweiligen Type aufgebrachte Codierungen ab, erfaßt die von der Codierung reflektierten Strahlen über eine Empfangsoptik und interpretiert sie mit Hilfe einer entsprechenden Logikeinrichtung. Nach der Identifizierung der Type der jeweils zugeführten Leiterplatte LP führt die Identifiziereinrichtung I1 dann der Recheneinrichtung R ein entsprechendes Identifikationssignal zu. Aufgrund dieses Identifikationssignals wird dann aus einer Vielzahl von in der Recheneinrichtung R gespeicherten Bestückprogrammen das der identifizierten Leiterplatte LP zugeordnete Bestückprogramm ausgewählt und aktiviert. Die an dem Handbestückplatz tätige Bedienperson legt dann die identifizierte Leiterplatte LP in die im dargestellten Ausführungsbeispiel als Fixierrahmen ausgebildete Aufnahme A ein. Die Aufnahme A ist dabei so ausgebildet, daß die Leiterplatten LP unverwechselbar positioniert werden können, was beispielsweise durch Vor- und Rücksprung in Aufnahme A und Leiterplatte LP oder durch Löchern der Leiterplatte LP zugeordnete Positionierstifte erreicht werden kann. Die Recheneinrichtung R steuert die in der Arbeitsfläche versenkbaren Hub- und Drehmagazine M1 und M2 bzw. die Stangenmagazine M3 entsprechend dem gewählten Bestückprogramm derart an, daß an demjenigen Fach F bzw. an demjenigen Stangenmagazin M3, welches das für den jeweiligen Bestückvorgang benötigte Bauelement B enthält, eine optische Anzeige OA1 bzw. OA2 aufleuchtet. Bei diesen optischen Anzeigen OA1 und OA2 handelt es sich beispielsweise um LED-Anzeigen. Bei den Hub- und Drehmagazinen M1 und M2 bewirkt die Recheneinrichtung R gleichzeitig eine derartige Verdrehung in Richtung der Doppelpfeile 2 und eine derartige Höhenverstellung in Richtung der Doppelpfeile 3, daß die Bedienperson die jeweils angesteuerten Bauelemente B von vorne und in geringer Höhe über der Arbeitsfläche entnehmen kann. Dabei können zur zusätzlichen Sicherheit durch eine entsprechende Steuerung der Recheneinrichtung R nur die stirnseitigen Klappen K derjenigen Fächer F geöffnet werden, die die für den jeweiligen Bestückvorgang benötigten Bauelemente B enthalten. Die aus den Hub- und Drehmagazinen M1 und M2 bzw. den Stangenmagazinen M3 entnommenen Bauelemente B werden dann in eine in Figur 1 nicht dargestellte Bauelemente-Vorbereitungseinrichtung eingelegt. Das Funktionsprinzip einer derartigen auf dem Arbeitstisch AT anzuordnenden Bauelemente-Vorbereitungseinrichtung BV geht aus den Figuren 5 und 6 hervor. Dort ist zu erkennen, daß die Bauelemente B derart eingelegt werden, daß ihre Anschlußbeinchen von zwei Klemmbackenpaaren KB1 und KB2 erfaßt und gespannt werden können. Die Klemmbackenpaare KB1 und KB2 können dabei entsprechend dem jeweiligen Bestückprogramm über die Recheneinrichtung R (vgl. Figur 1) auf ein zutreffendes Rastermaß RM eingestellt und in Richtung der Pfeile 4 bzw. 5 um 90° verschwenkt werden. Gegebenenfalls besitzt die Bauelemente-Vorbereitungseinrichtung BV auch zwei von der Recheneinrichtung R (vgl. Figur 1) gesteuerte Schneideinrichtungen SE1 und SE2, über welche die Anschlußbeinchen AB eines Bauelements B in der jeweils erforderlichen Länge abgeschnitten werden können. Figur 6 zeigt die Bauelemente-Vorbereitungseinrichtung BV mit einer um 90° verschwenkten Stellung der Klemmbackenpaare KB1 und KB2. In dieser Stellung sind die Anschlußbeinchen AB derart abgelängt und umgebogen, daß sie leicht an der vorgesehenen Bestückposition in die zugeordnete Leiterplatte LP (vgl. Figur 1) eingesetzt werden können.

Nach der vorstehend beschriebenen Vorbereitung eines aus den Hub- und Drehmagazinen M1 bzw. M2 oder den Stangenmagazinen M3 entnommenen Bauelements B wird dieses Bauelement B von der Bedienperson an der vorgesehenen Bestückposition in die zu bestückende Leiterplatte LP eingesetzt. Die Bestückposition wird dabei von der durch die Recheneinrichtung R gesteuerten Anzeigeeinrichtung AE durch auf die entsprechenden Bohrungen der Leiterplatte LP gerichtete Lichtstrahlen LS1 und LS2 optisch gekennzeichnet. Diese optische Kennzeichnung kann auch von unten vorgenommen werden und ggf. eine Aussage über die Polarität eines Bauelements B enthalten. Im dargestellten Fall werden die Lichtstrahlen LS1 und LS2 von oben über eine Ablenkoptik auf die Leiterplatte LP gerichtet, wobei die Steuerung dieser Ablenkoptik über einen Mikroprozessor der Anzeigeeinrichtung AE erfolgt und dieser Mikroprozessor seinerseits entsprechend dem jeweils aktivierten Bestückprogramm von der Recheneinrichtung R mit Steuerinformationen versorgt wird. Nach dem Einsetzen in die Leiterplatte LP werden dann die nach unten vorstehenden Anschlußbeinchen AB des Bauelements B durch das von der Recheneinrichtung R entsprechend dem jeweils aktivierten Bestückprogramm gesteuerte Unterwerkzeug U umgebogen. Durch dieses Umbiegen werden die eingesetzten Bauelemente B beim späteren Transport der Flachbaugruppen gegen Herausfallen gesichert. Falls die Ablängung der Anschlußbeinchen AB der Bauelemente B nicht bereits in der Bauelemente-Vorbereitungseinrichtung BV vorgenommen worden ist, kann diese Ablängung auch in dem Unterwerkzeug U vorgenommen werden.

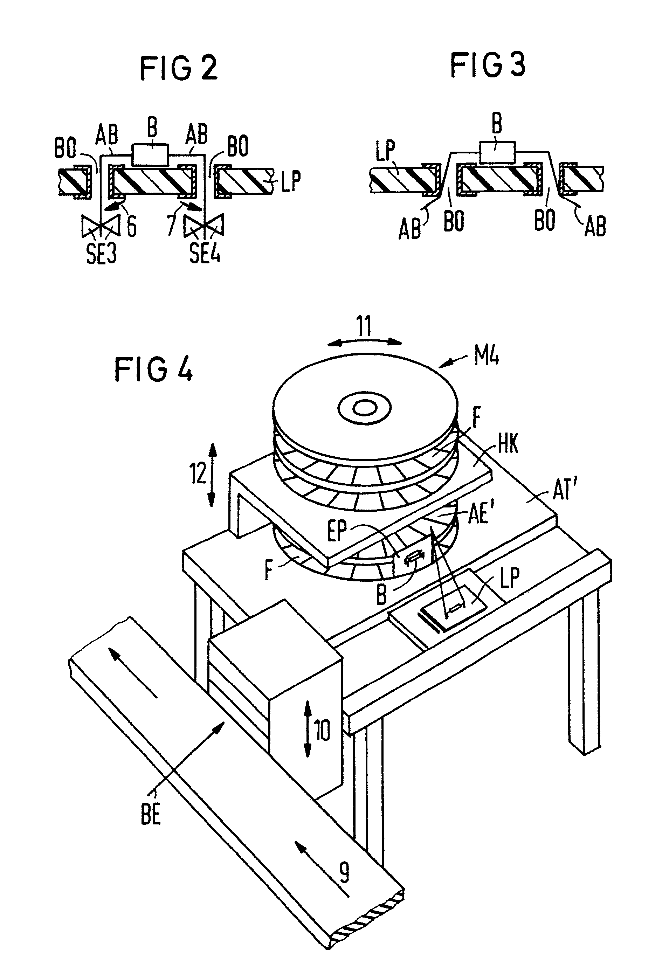

Die Figuren 2 und 3 zeigen das Funktionsprinzip des in Figur 1 erkennbaren Unterwerkzeugs U. Gemäß Figur 2 können die Anschlußbeinchen AB eines in die Bohrungen BO einer Leiterplatte LP eingesetzten Bauelements B durch von der Recheneinrichtung R (vgl. Figur 1) gesteuerte Schneideeinrichtungen SE3 und SE4 auf die jeweils erforderliche Länge gekürzt werden. Das Umbiegen der Anschlußbeinchen AB erfolgt durch von der Recheneinrichtung R (vgl. Figur 1) gesteuerte Biegeeinrichtungen, die in Figur 2 nur schematisch durch Pfeile 6 und 7 dargestellt sind. In der Praxis können die Schneideeinrichtungen SE3 und SE4 und die Biegeeinrichtungen 6 und 7 beispielsweise als integrierte Werkzeuge ausgebildet werden. Nach dem Umbiegen der Anschlußbeinchen AB ist gemäß Figur 3 die Lage eines Bauelements B auf der Leiterplatte LP so gesichert, daß es nicht mehr herausfallen kann.

Der vorstehend beschriebene Bestückvorgang wird so oft wiederholt, bis das letzte Bauelement B in der zugeordneten Bestückposition in die Leiterplatte LP eingesetzt ist und das Ende der Bestückung beispielsweise auf dem Bildschirm BS angezeigt wird. Die Bedienperson entnimmt dann die fertig bestückte Leiterplatte LP -die nach der vollständigen Bestückung als Flachbaugruppe zu bezeichnen ist- und legt sie auf die beispielsweise als Transportband ausgebildete Transporteinrichtung T2. Diese Transporteinrichtung T2 leitet dann die Flachbaugruppe in Richtung des Pfeiles 8 beispielsweise zum Löten weiter.

Die in Figur 2 dargestellte, als Handleseeinrichtung ausgebildete Identifiziereinrichtung I2 ist ebenfalls an die Recheneinrichtung R angeschlossen. Sie kann alleine zur Identifizierung der zu bestückenden Leiterplatten LP herangezogen werden oder auch nur bei einem Ausfall der stationären Identifiziereinrichtung I1 zur Identifizierung benutzt werden. Mit der Identifiziereinrichtung I2 können aber auch Bauelemente-Behälter identifiziert werden, die für den Nachschub zum Handbestückplatz transportiert werden.

Die in Figur 1 ferner erkennbare Tastatureinheit TE dient zur Eingabe von Steuerdaten, d.h. neben den im Bestückprogramm hinterlegten Verbrauchsstückzahlen können hier über Tasten Mehrverbrauch bzw. Ausschuß eingegeben werden. Störmeldungen und Informationen für den Nachschub von Bauelementen B können ebenfalls erfaßt werden.

Der Bildschirm BS der Recheneinrichtung R kann die Bedienperson beispielsweise über Besonderheiten der Bauelemente B informieren. Diese Besonderheiten können die Polarität eines einzusetzenden Bauelements B, Hinweise auf die Gefährdung elektrisch geförderter Bauelemente B betreffen.

Figur 4 zeigt eine Variante, bei welcher die zu bestückenden Leiterplatten LP über eine Transporteinrichtung T3 in Richtung des Pfeiles 9 einem Leiterplatten-Magazin LM mit mehreren Einschubebenen zugeführt werden. Die zu bestückenden Leiterplatten LP werden dann über eine in Figur 4 nur durch einen Pfeil angedeutete Be- und Entladeeinrichtung BE in eine der Einschubebenen des Leiterplatten-Magazins LM eingeschoben. Damit auf diese Weise sämtliche Einschubebenen zur Erreichung einer Pufferwirkung bestückt werden können, ist das Leiterplatten-Magazin LM höhenverstellbar angeordnet, wie es durch den Doppelpfeil 10 angedeutet ist. Die jeweils zu bestückende Leiterplatte LP wird mit Hilfe der Be- und Entladeeinrichtung BE aus dem Leiterplatten-Magazin LM und durch eine in Figur 4 nicht dargestellte Identifiziereinheit hindurch auf den Arbeitstisch AT' geschoben. Die Bedienperson ergreift dann die identifizierte Leiterplatte LP und legt sie in eine in Figur 4 nicht näher bezeichnete Aufnahme ein. Figur 4 zeigt ferner ein einziges Hub- und Drehmagazin M4, welches in Richtung des Doppelpfeiles 11 verdreht und in Richtung des Doppelpfeiles 12 in vertikaler Richtung verstellt werden kann. Das Hub- und Drehmagazin M4 besitzt dabei eine einzige von sämtlichen Fächern F anfahrbare, ortsfest angeordnete Entnahmeposition EP. Diese Entnahmeposition EP ist dabei so angeordnet, daß sie von einer Bedienperson besonders leicht erreicht werden kann. Da die Entnahmeposition EP automatisch durch die in Figur 4 nicht dargestellte Recheneinrichtung angefahren wird, können optische Anzeigen zur Kennzeichnung der Entnahmepositionen entfallen. Bei dem in Figur 4 dargestellten Ausführungsbeispiel ist außerdem die hier mit AE' bezeichnete Anzeigeeinrichtung an einer Haltekonsole HK der Hub- und Dreheinrichtung M4 befestigt, wodurch eine besonders platzsparende Anordnung auf dem Arbeitstisch AT' ermöglicht wird. Nach dem Ende des Bestückvorgangs wird dann die fertig bestückte Leiterplatte LP bzw. Flachbaugruppe entnommen und über die Transporteinrichtung T3 zum Löten weitergeleitet. Die Flachbaugruppen können aber auch in ein zusätzliches, auf der rechten Seite des Arbeitstisches AT' eingeordnetes Leiterplatten-Magazin eingelegt und über eine separate Transporteinrichtung für den Abtransport zum Löten weitergeleitet werden. Im übrigen entspricht die Funktionsweise des in Figur 4 nur teilweise dargestellten Handbestückplatzes der Funktion des in Figur 1 dargestellten Handbestückplatzes.

**Patentansprüche**

1. Einrichtung für die Handbestückung von Leiterplatten mit elektrischen und/oder elektronischen Bauelementen, mit
   - einer Aufnahme für die unverwechselbare Positionierung der zu bestückenden Leiterplatten,
   - einer Anzeigeeinrichtung zur optischen Kennzeichnung der jeweiligen Bestückpositionen der Bauelemente auf der in der Aufnahme positionierten Leiterplatte,
   - mindestens einem Magazin zur Bereitstellung der für die Bestückung benötigten Bauelemente und mit
   - einer Recheneinrichtung, welche die Anzeigeeinrichtung und die Entnahmepositionen der Bauelemente im Magazin entsprechend einem vorgebbaren Bestückprogramm steuert, wobei
   
   a) das Magazin (M1, M2, M3; M4) für die Bereitstellung sämtlicher Bauelemente (B) ausgelegt ist, die für ein zu fertigendes Flachbaugruppenspektrum benötigt werden,
   b) die Recheneinrichtung (R) Zugriff zu sämtlichen Bestückprogrammen des zu fertigenden Flachbaugruppenspektrums hat und
   c) an die Recheneinrichtung (R) zusätzlich eine Identifiziereinrichtung (I1, I2) angeschlossen ist, welche die jeweils zu bestückende Leiterplatte (LP) identifiziert und das zugeordnete Bestückprogramm in der Recheneinrichtung (R) aktiviert.

2. Einrichtung nach Anspruch 1, **gekennzeichnet** durch eine stationär angeordnete Identifiziereinrichtung (I1).

3. Einrichtung nach Anspruch 2, dadurch **gekennzeichnet,** daß die Identifiziereinrichtung (I1) Kennzeichnungen der Leiterplatten (LP) abtastet, die reflektierten Strahlen empfängt und interpretiert und der Recheneinrichtung (R) ein entsprechendes Identifikationssignal zuführt.

4. Einrichtung nach Anspruch 2 oder 3, dadurch **gekennzeichnet,** daß die zu bestückenden Leiterplatten (LP) der Identifiziereinrichtung (I1) über eine Transporteinrichtung (T1) zuführbar sind.

5. Einrichtung nach Anspruch 2 oder 3, dadurch **gekennzeichnet,** daß die zu bestückenden Leiterplatten (LP) der Identifiziereinrichtung (I1) aus einem Leiterplatten-Magazin (LM) zuführbar sind.

6. Einrichtung nach Anspruch 5, dadurch **ge-**

kennzeichnet, daß die zu bestückenden Leiterplatten (LP) dem Leiterplatten-Magazin (LM) über eine Transporteinrichtung (T3) zuführbar sind.

7. Einrichtung nach Anspruch 5 oder 6, dadurch gekennzeichnet, daß dem Leiterplatten-Magazin (LM) eine Be- und Entladeeinrichtung (BE) zugeordnet ist.

8. Einrichtung nach Anspruch 1, gekennzeichnet durch eine als Handleseeinrichtung ausgebildete Identifiziereinrichtung (I2).

9. Einrichtung nach den Ansprüchen 2 und 8, dadurch gekennzeichnet, daß sowohl eine stationär angeordnete Identifiziereinrichtung (I1) als auch eine als Handleseeinrichtung ausgebildete Identifiziereinrichtung (I2) vorgesehen sind.

10. Einrichtung nach einem der vorhergehenden Ansprüche, gekennzeichnet durch eine von der Recheneinrichtung (R) steuerbare Bauelemente-Vorbereitungseinrichtung (BV), welche die Anschlußbeinchen (AB) der aus dem Magazin (M1, M2, M3; M4) entnommenen Bauelemente (B) entsprechend dem Rastermaß der jeweiligen Bestückposition der in der Aufnahme positionierten Leiterplatte (LP) umbiegt.

11. Einrichtung nach einem der vorhergehenden Ansprüche, gekennzeichnet durch ein von der Recheneinrichtung (R) steuerbares Unterwerkzeug (U) zum Umbiegen und Sichern der Anschlußbeinchen (AB) der in die Leiterplatte (LP) eingesetzten Bauelemente (B).

12. Einrichtung nach Anspruch 10, dadurch gekennzeichnet, daß die Bauelemente-Vorbereitungseinrichtung (BV) eine Schneideinrichtung (SE3, SE4) zum Ablängen der Anschlußbeinchen (AB) in der für die jeweilige Bestückposition erforderlichen Länge umfaßt.

13. Einrichtung nach Anspruch 11, dadurch gekennzeichnet, daß das Unterwerkzeug (U) eine Schneideinrichtung (SE1, SE2) zum Ablängen der Anschlußbeinchen (AB) in der für die jeweilige Bestückposition erforderlichen Länge umfaßt.

14. Einrichtung nach einem der vorhergehenden Ansprüche, dadurch gekennzeichnet, daß das Magazin (M1, M2; M4) als turmförmiges Hub- und Drehmagazin mit in mehreren Ebenen sektorförmig angeordneten Fächern (F) ausgebildet ist.

15. Einrichtung nach Anspruch 14, dadurch gekennzeichnet, daß die Fächer (F) durch von der Recheneinrichtung (R) freigebbare Klappen (K) verschließbar sind.

16. Einrichtung nach Anspruch 14 oder 15, dadurch gekennzeichnet, daß zusätzlich zu dem als Hub- und Drehmagazin ausgebildeten Magazin (M1, M2) mindestens ein Stangenmagazin (M3) vorhanden ist.

17. Einrichtung nach einem der Ansprüche 14 bis 16, dadurch gekennzeichnet, daß die jeweilige von der Recheneinrichtung (R) angesteuerte Entnahmeposition eines Magazins (M1, M2, M3) durch eine optische Anzeige (OA1, OA2) anzeigbar ist.

18. Einrichtung nach Anspruch 14, dadurch gekennzeichnet, daß das als Hub- und Drehmagazin ausgebildete Magazin (M4) eine von sämtlichen Fächern (F) anfahrbare, ortsfest angeordnete Entnahmeposition (EP) besitzt.

19. Einrichtung nach einem der vorhergehenden Ansprüche, gekennzeichnet durch einen an die Recheneinrichtung (R) angeschlossenen Bildschirm (BS).

20. Einrichtung nach einem der vorhergehenden Ansprüche, gekennzeichnet durch eine an die Recheneinrichtung (R) angeschlossene Tastatureinheit (TE) für die Eingabe zusätzlicher Steuerdaten.

## Claims

1. Device for manually equipping printed-circuit boards with electric and/or electronic components, comprising
   - a receptacle for the unmistakable positioning of the printed-circuit boards to be equipped,
   - an indicating device for the visual identification of the respective equipping positions of the components on the printed-circuit board positioned in the receptacle,
   - at least one magazine for providing the components needed for the equipping and comprising
   - a computing device which controls the indicating device and the removal positions of the components in the magazine in accordance with a predeterminable equipping programme, wherein
   a) the magazine (M1, M2, M3, M4) is designed for the provision of all components (B) which are needed for a range of the flat modules to be fabricated,

b) the computing device (R) has access to all equipping programmes of the range of flat modules to be fabricated, and

c) the computing device (R) is additionally connected to an identifying device (I1, I2) which identifies the printed-circuit board (LP) in each case to be equipped and activates the associated equipping programme in the computing device (R).

2. Device according to Claim 1, characterised by a stationarily arranged identifying device (I1).

3. Device according to Claim 2, characterised in that the identifying device (I1) scans identifications on the printed-circuit boards (LP), receives and interprets the reflected rays and supplies a corresponding identification signal to the computing device (R).

4. Device according to Claim 2 or 3, characterised in that the printed-circuit boards (LP) to be equipped can be supplied to the identifying device (I1) by means of a transportation device (T1).

5. Device according to Claim 2 or 3, characterised in that the printed-circuit boards (LP) to be equipped can be supplied to the identifying device (I1) from a printed-circuit board magazine (LM).

6. Device according to Claim 5, characterised in that the printed-circuit boards (LP) to be equipped can be supplied to the printed-circuit board magazine (LM) by means of a transportation device (T3).

7. Device according to Claim 5 or 6, characterised in that the printed-circuit board magazine (LM) is associated with a loading and unloading device (BE).

8. Device according to Claim 1, characterised by an identifying device (I2) constructed as hand-held reading device.

9. Device according to Claims 2 and 8, characterised in that both a stationarily arranged identifying device (I1) and an identifying device constructed as hand-held reading device (I2) are provided.

10. Device according to one of the preceding claims, characterised by a component preparation device (BV) which can be controlled by the computing device (R) and which bends the terminal pins (AB) of the components (B) taken from the magazine (M1, M2, M3, M4) in accordance with the spacing dimension of the respective equipment position of the printed-circuit board (LP) positioned in the receptacle.

11. Device according to one of the preceding claims, characterised by a lower tool (U), which can be controlled by the computing device (R), for bending and securing the terminal pins (AB) of the components (B) inserted into the printed-circuit board (LP).

12. Device according to Claim 10, characterised in that the component preparation device (BV) comprises a cutting device (SE3, SE4) for cropping the terminal pins (AB) to the length required for the respective equipping postion.

13. Device according to Claim 11, characterised in that the lower tool (U) comprises a cutting device (SE1, SE2) for cropping the terminal pins (AB) to the length required for the respective equipping postion.

14. Device according to one of the preceding claims, characterised in that the magazine (M1, M2, M4) is designed as turret-shaped lifting and rotating magazine with compartments (F) arranged in sector form at several levels.

15. Device according to Claim 14, characterised in that the compartments (F) can be closed by flaps (K) which can be released by the computing device (R).

16. Device according to Claim 14 or 15, characterised in that in addition to the magazine (M1, M2) designed as lifting and rotating magazine, at least one bar magazine (M3) is included.

17. Device according to one of Claims 14 to 16, characterised in that the respective removal position, selected by the computing device (R), of a magazine (M1, M2, M3) can be indicated by a visual indicator (OA1, OA2).

18. Device according to Claim 14, characterised in that the magazine (M4), designed as lifting and rotating magazine, has a stationarily arranged removal position (EP) which can be approached by all compartments (F).

19. Device according to one of the preceding claims, characterised by a display screen (BS) connected to the computing device (R).

20. Device according to one of the preceding claims, characterised by a keyboard unit (TE), connected to the computing device (R), for the input of additional control data.

**Revendications**

1. Dispositif pour équiper manuellement des plaquettes à circuits imprimés avec des composants électriques et/ou électroniques, comportant
   - un logement pour le positionnement non permutable des plaquettes à circuits imprimés devant être équipées,
   - un dispositif indicateur pour caractériser optiquement les positions respectives de montage des composants sur la plaquette à circuits imprimés positionnée dans le logement,
   - au moins un magasin pour préparer les composants nécessaires pour le montage, et
   - un dispositif de calcul, qui commande le dispositif indicateur et les positions de prélèvement des composants dans le magasin en fonction d'un programme d'équipement pouvant être prédéterminé, et dans lequel
   a) le magasin (M1,M2,M3;M4) est conçu pour la préparation de tous les composants (B), qui sont nécessaires pour une gamme de modules plats devant être fabriqués,
   b) le dispositif de calcul (R) a accès à tous les programmes d'équipement de la gamme de modules plats devant être fabriqués, et
   c) le dispositif de calcul (R) est en outre raccordé à un dispositif d'identification (I1,I2), qui identifie la plaquette à circuits imprimés (LP) devant être respectivement équipée et active le programme associé d'équipement dans le dispositif de calcul (R).

2. Dispositif suivant la revendication 1, caractérisé par un dispositif d'identification (I1) monté fixe.

3. Dispositif suivant la revendication 2, caractérisé par le fait que le dispositif d'identification (I1) explore des marques des plaquettes à circuits imprimés (LP), reçoit et interprète le rayonnement réfléchi et envoie un signal d'identification correspondant au dispositif de calcul (R).

4. Dispositif suivant la revendication 2 ou 3, caractérisé par le fait que les plaquettes à circuits imprimés (LP) devant être équipées peuvent être envoyées au dispositif d'identification (I1) au moyen d'un dispositif de transport (T1).

5. Dispositif suivant la revendication 2 ou 3, caractérisé par le fait que les plaquettes à circuits imprimés (LP) devant être équipées peuvent être envoyées au dispositif d'identification (I1) à partir d'un magasin (LM) de plaquettes à circuits imprimés.

6. Dispositif suivant la revendication 5, caractérisé par le fait que les plaquettes à circuits imprimés (LP) devant être équipées peuvent être envoyées au magasin (LM) des plaquettes à circuits imprimés par l'intermédiaire d'un dispositif de transport (T3).

7. Dispositif suivant la revendication 5 ou 6, caractérisé par le fait qu'un dispositif de chargement et de déchargement (BE) est associé au magasin (LM) des plaquettes à circuits imprimés.

8. Dispositif suivant la revendication 1, caractérisé par un dispositif d'identification (I2) agencé sous la forme d'un dispositif manuel de lecture.

9. Dispositif suivant les revendications 2 et 8, caractérisé par le fait qu'il est prévu aussi bien un dispositif d'identification (I1) monté fixe qu'un dispositif d'identification (I2) agencé sous la forme d'un dispositif manuel de lecture.

10. Dispositif suivant l'une des revendications précédentes, caractérisé par un dispositif (BV) de préparation des composants, qui peut être commandé par le dispositif de calcul (R) et replie les pattes de raccordement (AB) des composants (B) prélevés du magasin (M1,M2,M3;M4), en fonction du pas du réseau des positions respectives d'équipement de la plaquette à circuits imprimés (LP) positionnée dans le logement.

11. Dispositif suivant l'une des revendications précédentes, caractérisé par un outil (U) situé en position inférieure, qui peut être commandé par le dispositif de calcul (R) et sert à replier et fixer les pattes de raccordement (AB) des composants (B) utilisés dans la plaquette à circuits imprimés (LP).

12. Dispositif suivant la revendication 10, caractérisé par le fait que le dispositif (BV) de préparation des composants comprend un dispositif de coupe (SE3,SE4) pour sectionner les pattes de raccordement (AB) à la longueur requise pour la position respective de montage.

13. Dispositif suivant la revendication 11, caractérisé par le fait que l'outil (U) situé en position inférieure comprend un dispositif de coupe (SE1,SE2) pour sectionner les pattes de raccordement (ATS) à la longueur requise pour la position respective de montage.

14. Dispositif suivant l'une des revendications précédentes, caractérisé par le fait que le magasin (M1,M2; M4) est réalisé sous la forme d'un magasin soulevable et rotatif en forme de tour, qui comporte des casiers (F) disposés selon des secteurs dans plusieurs plans.

15. Dispositif selon la revendication 14, caractérisé par le fait que les casiers (F) peuvent être fermés par des volets (K) pouvant être libérés par le dispositif de calcul (R).

16. Dispositif suivant la revendication 14 ou 15, caractérisé par le fait qu'en plus du magasin (M1,M2) agencé sous la forme d'un magasin soulevable et rotatif, il est prévu au moins un magasin à barres (M3).

17. Dispositif suivant l'une des revendications 14 à 16, caractérisé par le fait que la position respective de prélèvement, commandée par le dispositif de calcul (R), d'un magasin (M1,M2,M3) peut être indiquée au moyen d'une indication optique (OA1,OA2).

18. Dispositif suivant la revendication 14, caractérisé par le fait que le magasin (M4) réalisé sous la forme d'un magasin soulevable et rotatif, possède une position fixe de prélèvement (EP), dans laquelle peuvent venir tous les casiers (F).

19. Dispositif suivant l'une des revendications précédentes, caractérisé par un écran de visualisation (BS) raccordé au dispositif de calcul (R).

20. Dispositif suivant l'une des revendications précédentes, caractérisé par une unité à clavier (TE) raccordée au dispositif de calcul (R), pour l'introduction de données supplémentaires de commande.

# FIG 1

# FIG 2

# FIG 3

# FIG 4

## FIG 5

## FIG 6